Europäisches Patentamt

European Patent Office

Office européen des brevets

(11) Numéro de publication: **0 088 684**
**B1**

(19)

(12) **FASCICULE DE BREVET EUROPEEN**

(45) Date de publication du fascicule du brevet:
04.09.85

(21) Numéro de dépôt: 83400436.8

(22) Date de dépôt: 03.03.83

(51) Int. Cl.⁴: **G 01 R 31/28, G 21 C 17/00**

(54) Dispositif pour appliquer des signaux logiques de test à deux états sur une entrée d'un circuit logique et application aux tests automatiques d'une pluralité de circuits logiques.

(30) Priorité: 05.03.82 FR 8203711

(43) Date de publication de la demande:
14.09.83 Bulletin 83/37

(45) Mention de la délivrance du brevet:
04.09.85 Bulletin 85/36

(73) Titulaire: **COMMISSARIAT A L'ENERGIE ATOMIQUE Etablissement de Caractère Scientifique Technique et Industriel, 31/33, rue de la Fédération, F-75015 Paris (FR)**
Titulaire: **MERLIN GERIN, Rue Henri Tarze, F-38050 Grenoble Cedex (FR)**
Titulaire: **FRAMATOME ET CIE., Tour Fiat 1, Place de la Coupole, F-92400 Courbevoie (FR)**

(84) Etats contractants désignés:
**BE DE GB IT**

(56) Documents cités:
**EP - A - 0 024 671
DE - B - 2 438 257
FR - A - 2 181 866**

(72) Inventeur: **Collombet, Michel, 172 Bis Cours Berriat, F-38000 Grenoble (FR)**

(74) Mandataire: **Mongrédien, André et al, c/o BREVATOME 25, rue de Ponthieu, F-75008 Paris (FR)**

ACTORUM AG

## Description

La présente invention concerne un dispositif pour appliquer des signaux logiques de test à deux états, sur une entrée d'un circuit logique. Cette invention s'applique plus particulièrement au test d'un circuit logique dont une sortie fournit des signaux dont les états logiques dépendent des états logiques des signaux de commande appliqués sur l'une de leurs entrées par un moyen de commande. Elle permet, sans avoir à déconnecter le moyen de commande d'avec le circuit logique auquel il est relié, d'imposer des signaux de test à l'entrée de ce circuit logique, de manière à vérifier les signaux résultants en sortie, quel que soit l'état logique des signaux fournis simultanément par le moyen de commande. Ce dispositif s'applique notamment aux tests de circuits logiques qui permettent de déclencher des actions urgentes dans des réacteurs nucléaires, à partir de signaux logiques fournis par des moyens de commande constitués par des capteurs dont les sorties fournissent des signaux de commande de type «tout ou rien»; ces signaux de commande présentent en fait des états logiques 1 ou 0.

L'invention s'applique aussi aux tests automatiques d'une pluralité de circuits logiques, par des signaux de test à deux états logiques, appliqués aux entrées de ces circuits, sans qu'il soit nécessaire de déconnecter ces circuits d'avec les moyens de commande qui appliquent des signaux logiques sur leurs entrées.

On ne connaît pas actuellement de dispositif de test qui permet d'appliquer des signaux logiques de test aux entrées d'un circuit logique commandé par un moyen de commande, sans déconnecter ce moyen d'avec le circuit logique. Généralement, lorsqu'il est nécessaire de tester un circuit logique en appliquant sur une entrée de ce circuit des signaux de test pour observer en sortie les signaux résultants correspondants, on déconnecte le moyen de commande de ce circuit logique, de façon que les signaux de commande ne viennent pas perturber les signaux de test et qu'inversement, les signaux de test ne viennent pas perturber le fonctionnement du moyen de commande. Le fait de déconnecter le moyen de commande d'avec le circuit logique a pour principal inconvénient de laisser un doute sur la transmission des signaux de commande au circuit logique, lorsque le test étant terminé, le moyen de commande est à nouveau connecté au circuit logique. En effet, il se peut qu'au cours de cette connexion après un test, des faux contacts apparaissent dans la connexion de la sortie du moyen de commande avec l'entrée du circuit logique.

L'invention a pour but de remédier à ces inconvénients et notamment de réaliser un dispositif permettant d'appliquer des signaux logiques de test à deux états, sur une entrée d'un circuit logique, sans qu'il soit nécessaire, pour effectuer ce test, de déconnecter les moyens de commande de ce circuit logique et sans que les signaux de test ne viennent perturber le moyen de commande ou que les signaux de commande viennent perturber les signaux de test; les signaux de test sont en fait, grâce au dispositif de l'invention, forcés à l'entrée de commande du circuit logique. Le dispositif permet aussi d'effectuer automatiquement des tests d'une pluralité de circuits logiques, sans déconnecter ces circuits d'avec leurs moyens de commande.

L'invention a pour objet un dispositif pour appliquer des signaux logiques de test à deux états, sur une entrée d'un circuit logique, ce circuit logique fournissant sur une sortie des signaux présentant deux états logiques dépendant respectivement de deux états logiques de signaux de commande appliqués sur son entrée par une sortie d'un moyen de commande, caractérisé en ce qu'il est constitué par des moyens pour imposer chaque état logique des signaux de test à l'entrée du circuit logique, quel que soit l'état logique des signaux de commande.

Selon une autre caractéristique de l'invention, les moyens pour forcer chaque état logique (0 ou 1) des signaux de test à l'entrée du circuit logique, comprennent une source électrique de tension présentant une borne positive et une borne négative, la borne négative étant reliée à une masse de référence, les potentiels des bornes positive et négative de la source représentant respectivement les états logiques 1 et 0, et des moyens pour relier l'entrée du circuit logique à la borne positive de la source, à chaque fois qu'un signal de test présentant l'état logique 1 doit être appliqué à cette entrée, pour relier l'entrée du circuit logique à la masse de référence et pour interdire l'application du potentiel de la borne positive de la source à l'entrée du circuit, à chaque fois qu'un signal de test présentant l'état logique 0 doit être appliqué à l'entrée du circuit logique.

Selon un premier mode de réalisation de l'invention, les moyens pour relier l'entrée du circuit à la borne positive de la source comprennent une résistance connectée entre l'entrée du circuit logique et la borne positive de la source électrique, les moyens pour relier l'entrée du circuit à la masse de référence et pour interdire l'application du potentiel de la borne positive comprennent un interrupteur connecté entre l'entrée du circuit et la masse de référence, l'ouverture ou la fermeture de cet interrupteur ($I_T$) correspondant respectivement aux états logiques 1 ou 0 des signaux de test, et une autre résistance connectée en série entre l'entrée du circuit et la sortie du moyen de commande.

Selon une autre caractéristique, pour ce deuxième mode de réalisation, le dispositif comporte en outre au moins une diode connectée en série avec l'une des deux résistances.

Selon une autre caractéristique, pour ce premier mode de réalisation, les résistances et les diodes sont connectées à demeure à l'entrée du circuit logique, la source électrique de courant ainsi que l'interrupteur étant amovibles et n'étant respectivement connectés avec la résistance et avec l'entrée du circuit qu'au moment d'un test.

Selon un deuxième mode de réalisation de l'invention, les moyens pour relier l'entrée du circuit avec la borne positive de la source et pour la relier à la masse de référence et interdire le débit de la source comprennent une résistance reliée à la borne positive de la source et à une première borne d'un interrupteur à deux positions, cette première borne correspondant à la première position, cet interrupteur présentant une deuxième borne correspondant à la deuxième position et qui est reliée à la masse de référence, et une borne commune aux deux positions, reliée à l'entrée du circuit, la première position correspondant à l'application d'un signal de test présentant l'état logique 1 et la deuxième position correspondant à l'application d'un signal de test présentant l'état logique 0, et une autre résistance connectée entre l'entrée du circuit logique et la sortie du moyen de commande.

Selon une autre caractéristique, pour ce deuxième mode de réalisation, le dispositif comporte en outre une diode connectée entre l'entrée du circuit logique et la sortie du moyen de commande.

Selon une autre caractéristique, pour ce deuxième mode de réalisation, la résistance, l'interrupteur et la source électrique sont amovibles, la diode et l'autre résistance étant reliées à demeure à l'entrée du circuit logique.

Selon une autre caractéristique, le moyen de commande est un capteur dont la sortie fournit des signaux de type tout ou rien (états logiques 1 ou 0).

Enfin, le dispositif de l'invention s'applique aux tests automatiques d'une pluralité de circuits logiques, par des signaux de tests à deux états logiques, appliqués aux entrées de ces circuits.

L'invention sera mieux comprise à l'aide de la description qui va suivre, donnée en référence aux figures schématiques annexées dans lesquelles:

la fig. 1 représente schématiquement un premier mode de réalisation d'un dispositif conforme à l'invention,

la fig. 2 représente schématiquement un deuxième mode de réalisation d'un dispositif conforme à l'invention,

la fig. 3 est un schéma qui montre l'application du premier mode de réalisation du dispositif aux tests automatiques d'une pluralité de circuits logiques,

la fig. 4 est un schéma qui montre l'application du deuxième mode de réalisation du dispositif aux tests automatiques d'une pluralité de circuits logiques.

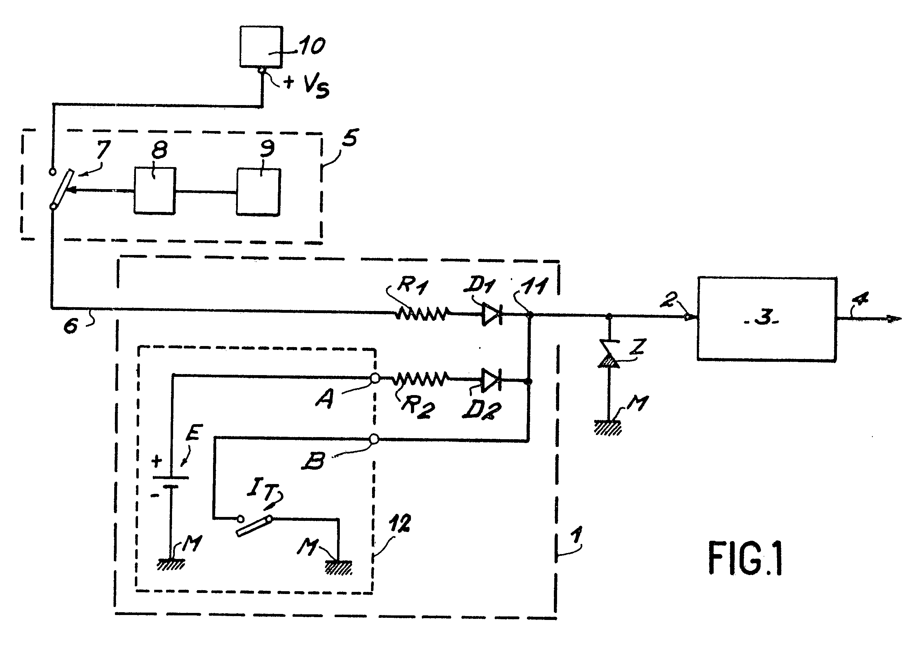

On a représenté schématiquement sur la fig. 1 un premier mode de réalisation d'un dispositif 1 de test, conforme à l'invention; ce dispositif permet d'appliquer des signaux logiques de test à deux états 0 ou 1, sur une entrée 2 d'un circuit logique 3. Ce circuit logique fournit, sur une sortie 4, des signaux présentant deux états logiques qui dépendent respectivement des deux états logiques de signaux de commande appliqués sur son entrée 2. Ces signaux de commande sont des signaux dont les états logiques sont 1 ou 0; ils sont fournis par la sortie d'un moyen de commande 5 qui peut être par exemple un capteur à seuil représenté schématiquement sur la figure par un interrupteur commandable 7 recevant des signaux de commande d'un détecteur de seuil 8, lui-même relié à un capteur 9 sensible aux variations d'un phénomène physique. Dès qu'un seuil de tension est dépassé en sortie du capteur 9, le détecteur de seuil 8 peut par exemple commander la fermeture de l'interrupteur 7, de manière que la sortie 6 du moyen de commande présente une tension égale à la tension +VS de sortie d'une source électrique de tension 10. Cette tension +VS peut être considérée comme représentative d'un état logique 1 sur la sortie 6 du moyen de commande 5. Lorsque l'interrupteur 7 est ouvert, la sortie 6 du moyen 5 est au potentiel de la masse de référence M, qui peut être considéré comme représentatif de l'état logique 0. Il est bien évident que le moyen de commande 5 qui est considéré, dans cet exemple de réalisation, comme un capteur à seuil associé à un interrupteur commandable 7, pourrait être constitué par tout autre circuit dont la sortie fournit des signaux de commande «tout ou rien», c'est-à-dire des signaux d'états logiques 0 ou 1. Le dispositif de test 1 de l'invention est constitué par des moyens qui permettent de forcer chaque état logique des signaux de test (état logique 0 ou état logique 1) à l'entrée 2 du circuit logique 3, quel que soit l'état logique des signaux de commande à la sortie 6 du moyen de commande 5. Les moyens 1 qui permettent d'imposer des signaux de test, d'états logiques 1 ou 0, à l'entrée 2 du circuit logique 3, comprennent en fait, dans ce premier mode de réalisation de l'invention ainsi que dans un deuxième mode de réalisation qui sera décrit plus loin en détail, une source électrique E de tension sensiblement égale à la tension +VS, qui présente une borne positive et une borne négative. La borne négative est reliée à une masse de référence M et les potentiels des bornes positive et négative de la source E, représentent respectivement les états logiques 1 et 0. Les moyens qui permettent d'imposer chaque état logique à l'entrée du circuit logique 3 comprennent aussi des moyens qui seront décrits plus loin en détail, qui permettent de relier l'entrée 2 du circuit logique 3 à la borne positive de la source E, à chaque fois qu'un signal de test présentant l'état logique 1 doit être appliqué à l'entrée de ce circuit logique. Ces moyens permettent également de relier l'entrée du circuit logique à la masse de référence pour interdire l'application du potentiel de la borne positive de la source vers l'entrée du circuit à chaque fois qu'un signal de test présentant l'état logique 0 doit être appliqué à l'entrée de ce circuit.

Dans ce premier mode de réalisation du dispositif de l'invention, les moyens qui permettent de relier l'entrée 2 du circuit à la borne positive de la source E comprennent une résistance $R_2$ dont une première borne est reliée à l'anode d'une diode $D_2$, la cathode de cette diode étant reliée à l'entrée 2 du circuit logique 3; une deuxième borne A de la résistance $R_2$ est reliée à la borne positive de la source électrique E; les moyens qui permettent de relier l'entrée du circuit logique 3 à la masse de référence M et qui permettent d'interdire l'application du potentiel de la borne positive de la source E vers l'entrée de ce circuit comprennent un inter-

rupteur $I_T$ connecté entre l'entrée 2 du circuit 3 et la masse de référence M. Comme on le verra plus loin en détail, l'ouverture ou la fermeture de l'interrupteur $I_T$ correspond respectivement aux états logiques 1 ou 0 des signaux de test à appliquer à l'entrée 2 du circuit 3.

Dans ce mode de réalisation, le dispositif de l'invention comprend en outre une autre résistance $R_1$ connectée en série avec une autre diode $D_1$, entre l'entrée 2 du circuit logique 3 et la sortie 6 des moyens de commande 5, la cathode de la diode $D_1$ étant reliée à l'entrée 2 du circuit logique.

On a également représenté sur cette figure une diode de Zener Z reliée entre le point commun 11 des cathodes des diodes $D_1$ et $D_2$ et la masse de référence M. Cette diode de Zener, qui n'est pas indispensable, permet en fait, dans certaines applications particulières, de fournir au circuit logique 3 une tension de niveau constant.

Le fonctionnement du dispositif sera mieux compris à l'aide du tableau suivant qui représente la position ouverte ou fermée de l'interrupteur 7, l'état logique des signaux à la sortie 6 du moyen de commande 5 ainsi qu'à l'entrée 2 du circuit logique 3 puis, au cours du test, la position ouverte ou fermée de l'interrupteur $I_T$, ainsi que les états logiques correspondants des signaux de test, à l'entrée 2 du circuit logique 3.

*Tableau*

| Positions de l'interrupteur 7 | Etats logiques des signaux de commande (sortie 6 et entrée 2) | Positions de l'interrupteur de test $I_T$ | Etats logiques des signaux à l'entrée 2 |
|---|---|---|---|
| ouverte | 0 | ouverte<br>fermée | 1<br>0 |
| fermée | 1 | ouverte<br>fermée | 1<br>0 |

Lorsque l'interrupteur 7 du moyen de commande 5 est en position ouverte, la sortie 6 est à l'état logique 0; cet état logique se retrouve à l'entrée 2 du circuit logique 3. Mais si l'interrupteur de test $I_T$ est ouvert, la tension de la borne positive de la source E se retrouve au point commun 11 aux cathodes des diodes $D_1$ et $D_2$. Cette tension positive correspond à l'état logique 1 à l'entrée 2 du circuit logique 3. On voit donc que dans ce cas, bien que l'état logique des signaux à la sortie 6 du moyen de commande 5 est 0, le dispositif de test impose à l'entrée 2 du circuit logique 3 l'état logique 1.

Si l'interrupteur $I_T$ est maintenant dans la position fermée, alors que l'interrupteur 7 du moyen de commande 5 est toujours dans la position ouverte, le courant fourni par la source E circule dans la résistance $R_2$ vers la masse M. La cathode de la diode $D_2$ est donc au potentiel de cette masse et il en résulte que la tension au point commun 11 des cathodes des diodes $D_1$ et $D_2$ est égale au potentiel de la masse M. Dans ce cas, l'état logique du signal appliqué 2 à l'entrée du circuit logique 3 est l'état logique 0.

Si maintenant, l'interrupteur 7 du moyen de commande 5 est en position fermée, le potentiel +VS de la source 10 se trouve à la sortie 6 du moyen de commande 5, et cette sortie se trouve donc dans l'état logique 1. Cet état logique, en l'absence de test, se retrouve normalement à l'entrée 2 du circuit logique 3.

Si l'interrupteur $I_T$ est en position ouverte, le potentiel de la borne positive de la source E se retrouve sur l'anode de la diode $D_T$. Le point 11 est donc à un potentiel égal à la plus grande des valeurs des potentiels de la source E et de la source +VS. Ce potentiel correspond à l'état logique 1 et correspond donc à l'état logique du signal de commande fourni sur la sortie 6 du moyen de commande 5. Au contraire, si l'interrupteur de test $I_T$ est en position fermée, le courant fourni par la source E circule dans la résistance $R_2$ en direction de la masse M, et un courant circule également dans la résistance $R_1$ qui absorbe la différence de potentiel entre les points 6 et 11. Le point commun 11 des cathodes des diodes $D_1$ et $D_2$ se trouve au potentiel de la masse M, correspondant à l'état logique 0. Dans ce cas, alors que le signal de commande fourni par la sortie 6 du moyen de commande 5 est dans l'état logique 1, le signal à l'entrée 2 du circuit logique 3 est à l'état logique 0; cet état logique est imposé par le dispositif de test.

Il résulte de ces observations que le dispositif de test permet d'imposer les états logiques des signaux de test à l'entrée du circuit logique 3, quel que soit l'état logique du signal fourni sur la sortie 6 du moyen de commande 5.

Pour faciliter le test et notamment dans le cas où une pluralité de circuits logiques tels que le circuit 3 sont reliés respectivement à la sortie de moyens de commande tels que le moyen de commande 5, les résistances $R_1$, $R_2$ et les diodes $D_1$, $D_2$ sont connectées à demeure à la sortie du moyen de commande 5, les signaux de commande du circuit logique 3 étant disponibles au point commun 11 des cathodes des diodes $D_1$ et $D_2$. La source électrique de courant E ainsi que l'interrupteur $I_T$ sont amovibles (tel que représenté par le rectangle 12) et ne sont connectés aux points A et B, qu'au moment où un test d'un circuit logique est à effectuer. Le rectangle 12 peut être un boîtier renfermant les composants indiqués, relié à la masse M.

Les diodes $D_1$ et $D_2$ permettent d'éviter le passage de courants, notamment lors d'un test, soit en direction de la source E à partir de la source 10, soit en direction de la source 10 à partir de la source E.

Le dispositif qui vient d'être décrit permet d'atteindre les buts mentionnés plus haut: il permet de tester un circuit logique par des signaux de test appliqués sur son entrée, sans avoir à déconnecter ce circuit logique du moyen de commande qui applique des signaux de commande sur cette entrée. Il permet aussi d'imposer l'état logique des signaux de test quel que soit l'état logique des signaux de commande. Ce dispositif est particulièrement destiné aux tests de circuits logiques qui permettent d'actionner des organes de sûreté dans des centrales nucléaires. En effet, il est indispensable que ces circuits logiques puissent être testés rapidement, sans avoir à les déconnecter de leurs moyens de commande, puisque toute déconnexion à des fins de test, suivie d'une connexion après test, peut entraîner des faux contacts préjudiciables à la sécurité de la centrale nucléaire.

Dans l'actionnement d'organes de sûreté dans des centrales nucléaires, le dispositif décrit va bien dans le sens de la sûreté. En effet, le déclenchement d'une action grâce au circuit logique 3 se fait par l'application d'un signal d'état logique 1, à l'entrée 2 du circuit 3. Lorsque les éléments amovibles 12 du dispositif sont connectés en A et B, un signal d'état logique 1 est obligatoirement appliqué à l'entrée 2 du circuit 3, quelle que soit la position ouverte ou fermée de l'interrupteur 7. L'interrupteur $I_T$ est un interrupteur dont la position normale est ouverte, en l'absence de commande de fermeture.

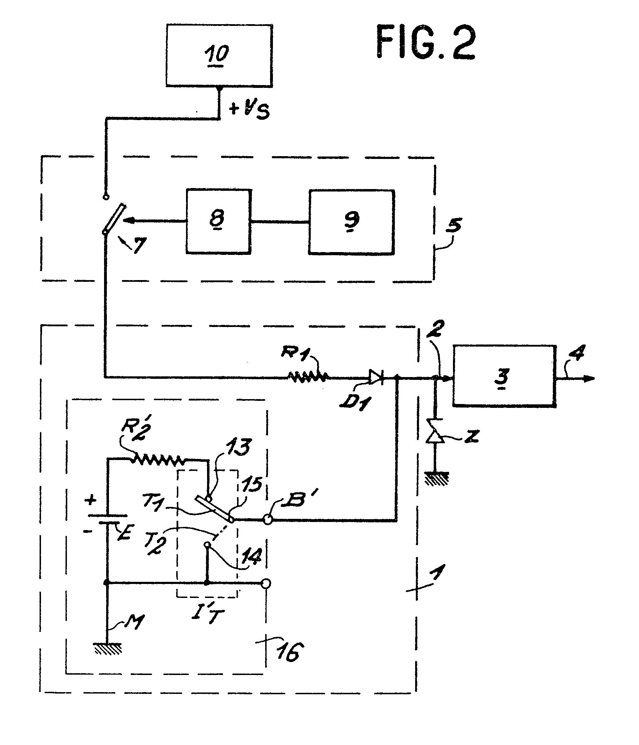

La fig. 2 représente schématiquement un autre mode de réalisation du dispositif de l'invention. Les mêmes éléments portent les mêmes références sur cette figure et sur la fig. 1.

Dans ce mode de réalisation, les moyens pour relier l'entrée 2 du circuit 3 avec la borne positive de la source E, pour relier cette entrée avec la masse de référence et pour interdire l'application du potentiel de la borne positive de la source E, comprennent une résistance $R'_2$ reliée à la borne positive de la source E et à une première borne 13 d'un interrupteur $I_T$ à deux positions. La résistance $R'_2$ peut être remplacée par une diode. Cette première borne correspond à une première position de cet interrupteur qui comprend en outre une deuxième borne 14, correspondant à une deuxième position, cette deuxième borne est reliée à une masse de référence M. Une borne 15 de cet interrupteur est commune aux deux positions de celui-ci et elle est reliée à l'entrée 2 du circuit 3. La première position de l'interrupteur correspond à l'application d'un signal de test présentant l'état logique 1 sur l'entrée 2 du circuit, tandis que la deuxième position de l'interrupteur correspond à l'application d'un signal de test présentant l'état logique 0 sur cette entrée.

Dans ce mode de réalisation, le dispositif comprend aussi une résistance $R_1$ connectée en série avec une diode $D_1$, entre l'entrée du circuit logique 3 et la sortie 6 du moyen de commande 5, la cathode de la diode $D_1$ étant reliée à l'entrée de ce circuit logique. Le moyen de commande 5 n'est pas ici décrit en détail, puisqu'il est constitué de la même façon que celui qui a été décrit à la fig. 1. Comme dans le mode de réalisation précédent, une diode Zener Z relie l'entrée 2 du circuit 3 avec la masse M.

Le fonctionnement du dispositif sera mieux compris à l'aide du tableau suivant qui représente la position ouverte ou fermée de l'interrupteur 7, l'état logique des signaux à la sortie 6 du moyen de commande 5, ainsi qu'à l'entrée 2 du circuit logique 3, puis, au cours des tests, les deux positions de l'interrupteur $I'_T$, ainsi que les états logiques correspondants des signaux de test à l'entrée du circuit logique 3. Les deux positions de l'interrupteur $I'_T$ sont désignées respectivement par les références $T_1$ et $T_2$.

*Tableau*

| Positions de l'interrupteur 7 | Etats logiques des signaux de commande (sortie 6 et entrée 2) | Positions de l'interrupteur de test $I'_T$ | Etats logiques des signaux à l'entrée 2 |
|---|---|---|---|
| ouverte | 0 | $T_1$ $T_2$ | 1 0 |
| fermée | 1 | $T_1$ $T_2$ | 1 0 |

Lorsque l'interrupteur 7 du moyen de commande 5 est en position ouverte, la sortie 6 est à l'état logique 0; cet état logique se retrouve à l'entrée 2 du circuit logique 3, si l'interrupteur $I'_T$ est dans la position $T_2$. En effet, dans ce cas, la source E n'est pas reliée à l'entrée 2 du circuit 3. Au contraire, si l'interrupteur $I'_T$ est dans la position $T_1$, la source E se trouve en liaison avec l'entrée 2, par l'intermédiaire de la résistance $R'_2$ et un signal de test d'état logique 1 est appliqué sur l'entrée du circuit 3, même si le signal du moyen de commande 5 est à l'état logique 0.

Si l'interrupteur 7 du moyen de commande 5 est fermé, que l'interrupteur $I'_T$ est dans la position $T_1$, le moyen de commande 5 applique à l'entrée 2 du circuit 3 un signal de commande dont l'état logique est 1, tandis que l'interrupteur $I'_T$ applique lui aussi sur cette entrée du circuit logique 3 un signal de test d'état logique 1. Au contraire, si le signal de commande appliqué sur l'entrée 2 du circuit 3 est un signal d'état logique 1 (interrupteur 7 fermé) et que l'interrupteur I'$_T$ est dans la position T$_2$, la source E n'est plus reliée à l'entrée 2 du circuit et le circuit de commande 5 est relié à la masse de référence M, à travers la résistance R$_1$ et la diode D$_1$. Il en résulte, dans ce cas, que le signal appliqué à l'entrée 2 du circuit logique 3 est un signal d'état logique 0, bien que le signal de commande soit à l'état logique 1.

La résistance R'$_2$ est nécessaire pour éviter que E ne débite dans 10, ou au moins limiter le débit. Elle est également nécessaire du fait de la diode Zener Z.

Il résulte de ces observations que le dispositif de test permet d'imposer les états logiques des signaux de test à l'entrée du circuit logique 3, quel que soit l'état logique du signal fourni sur la sortie 6 du moyen de commande 5. Comme dans le mode de réalisation précédent, notamment dans le cas où une pluralité de circuits logiques tels que le circuit 3 sont reliés respectivement à la sortie de moyens de commande tels que le moyen 5, la résistance R', l'interrupteur I'$_T$ et la source électrique E sont amovibles, contenus dans un même boîtier 16 par exemple, qui est lui-même relié à la masse M. La résistance R$_1$ ainsi que la diode D$_1$ sont connectées à demeure à l'entrée 2 du circuit 3. La boîtier amovible 16 n'est connecté au point B' qu'au moment où un test d'un circuit logique doit être effectué. Comme dans le mode de réalisation précédent, une diode Zener Z relie l'entrée 2 du circuit 3 avec la masse de référence afin que le niveau de tension (pour l'état logique 1) appliqué à ce circuit logique, pour le commander ou au moment d'un test, soit constant.

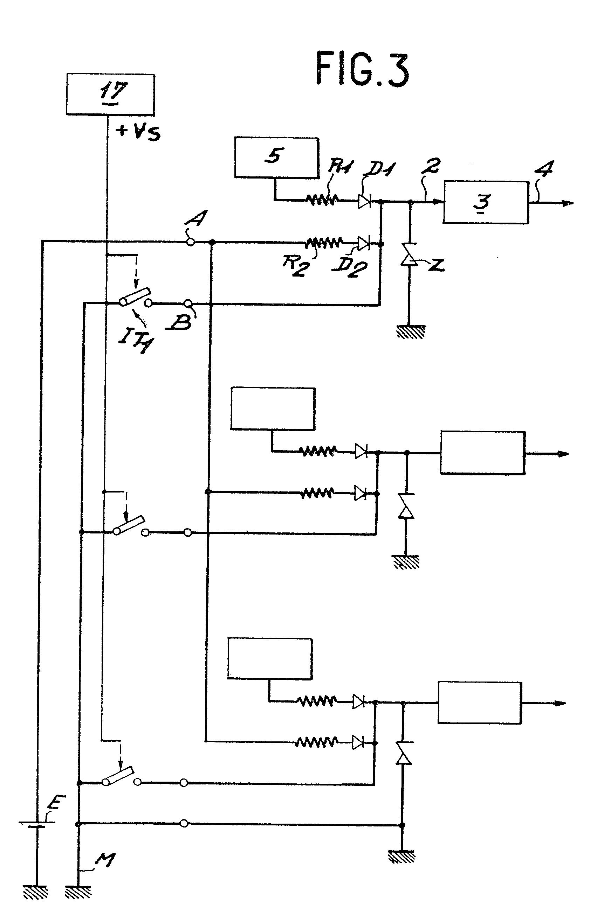

La fig. 3 représente schématiquement l'application du premier mode de réalisation du dispositif de l'invention, à des tests automatiques, d'une pluralité de circuits logiques tels que le circuit 3, dont la sortie 4 fournit des signaux présentant deux états logiques dépendant respectivement des deux états logiques de signaux de commande appliqués sur son entrée 2. Les mêmes éléments portent les mêmes références sur cette figure et sur la fig. 1. Les moyens de commande 5 n'ont pas été représentés ici en détail.

Dans cette application du dispositif, aux tests automatiques de circuits logiques tels que le circuit 3, un interrupteur I$_{T1}$ est nécessaire pour mettre en relation chaque circuit logique 3 avec la masse M. Les interrupteurs I$_{T1}$ sont commandés par un séquenceur 17 qui n'est pas représenté ici en détail. Ce séquenceur permet de commander la fermeture des interrupteurs I$_{T1}$ en fonction des états logiques des signaux de test appliqués sur l'entrée du circuit que l'on désire tester. Les interrupteurs I$_{T1}$ sont bien entendu supposés être des interrupteurs commandables électriquement. Une seule connexion avec la source E est nécessaire et suffisante pour tester l'ensemble des circuits, selon des configurations quelconques. Seuls les interrupteurs I$_{T1}$ sont nécessaires.

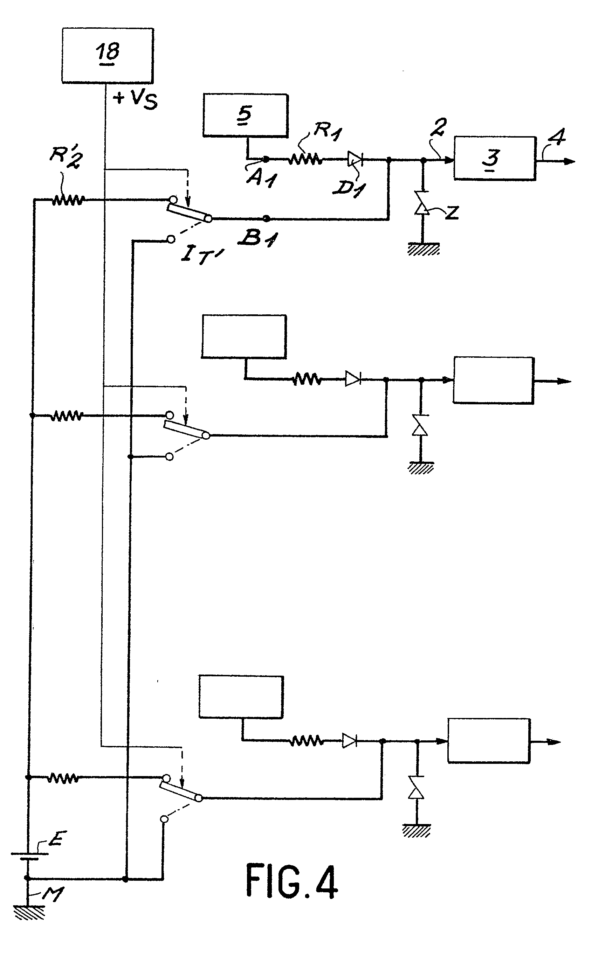

La fig. 4 représente schématiquement une application du deuxième mode de réalisation du dispositif à des tests automatiques d'une pluralité de circuits logiques. Les mêmes éléments portent les mêmes références sur cette figure et sur la fig. 2. Comme dans le cas précédent, on voit sur cette figure que le dispositif conforme au deuxième mode de réalisation de l'invention peut être appliqué aux tests de circuits logiques tels que le circuit 2. Les moyens de commande 5 de chacun de ces circuits logiques n'ont pas été représentés en détail sur cette figure. Les interrupteurs I'$_T$ sont reliés d'une part à la source électrique E par l'intermédiaire de résistances R'$_2$ et, d'autre part, à la masse de référence M. Un séquenceur 18 peut permettre ici de commander automatiquement les tests de chacun des circuits. Il est supposé dans ce cas que les interrupteurs I'$_T$ à deux positions sont des interrupteurs à commande électrique; cette commande n'a pas été représentée ici en détail.

Il est bien évident que dans le dispositif conforme à l'invention les moyens utilisés auraient pu être remplacés par des moyens équivalents, sans sortir du cadre de l'invention.

## Revendications

1. Dispositif pour appliquer des signaux logiques de test à deux états (0 ou 1), sur une entrée (2) d'un circuit logique (3), ce circuit logique fournissant sur une sortie (4) des signaux présentant deux états logiques (0 ou 1) de signaux de commande appliqués sur son entrée (2) par une sortie (6) d'un moyen de commande (5), caractérisé en ce qu'il est constitué par des moyens (1) pour imposer chaque état logique des signaux de test à l'entrée (2) du circuit logique, quel que soit l'état logique des signaux de commande.

2. Dispositif selon la revendication 1, caractérisé en ce que les moyens (1), pour imposer chaque état logique (0 ou 1) des signaux de test à l'entrée (2) du circuit logique (3), comprennent une source électrique (E) de tension présentant une borne positive et une borne négative, la borne négative étant reliée à une masse de référence (M), les potentiels des bornes positive et négative de la source représentant respectivement les états logiques 1 et 0, et des moyens pour relier l'entrée du circuit logique à la borne positive de la source, à chaque fois qu'un signal de test présentant l'état logique 1 doit être appliqué à cette entrée, pour relier l'entrée du circuit logique à la masse de référence et pour interdire l'application du potentiel de la borne positive de la source à l'entrée du circuit, à chaque fois qu'un signal de test présentant l'état logique 0 doit être appliqué à l'entrée du circuit logique.

3. Dispositif selon la revendication 2, caractérisé en ce que lesdits moyens pour relier l'entrée du circuit à la borne positive de la source comprennent une résistance (R$_2$) connectée entre l'entrée du circuit logique et la borne positive de la source électrique (E), les moyens pour relier l'entrée du circuit à la masse de référence et pour interdire l'application du potentiel de la borne positive de la source comprennent un interrupteur (I$_T$) connecté

entre l'entrée du circuit et la masse de référence, l'ouverture ou la fermeture de cet interrupteur ($I_T$) correspondant respectivement aux états logiques 1 ou 0 des signaux de test, et une autre résistance ($R_1$) connectée entre l'entrée du circuit logique et la sortie (6) du moyen de commande (5).

4. Dispositif selon la revendication 3, caractérisé en ce qu'il comporte au moins une diode ($D_1$) ($D_2$) connectée en série avec l'une des résistances ($R_1$) ($R_2$).

5. Dispositif selon l'une au moins des revendications 3 et 4, caractérisé en ce que les diodes éventuelles ($D_2$, $D_1$) et les résistances ($R_2$, $R_1$) sont connectées à demeure à l'entrée du circuit logique, la source électrique (E) de courant ainsi que l'interrupteur ($I_T$) étant amovibles et n'étant respectivement connectés avec la résistance ($R_2$) et avec l'entrée du circuit qu'au moment d'un test.

6. Dispositif selon la revendication 2, caractérisé en ce que les moyens pour relier l'entrée (2) du circuit (3) avec la borne positive de la source (E) et pour relier cette entrée à la masse de référence et interdire l'application du potentiel de la borne positive de la source comprennent une résistance ($R'_2$) reliée à la borne positive de la source (E) et à une première borne d'un interrupteur ($I'_T$) à deux positions, cette première borne (13) correspondant à la première position, cet interrupteur présentant une deuxième borne (14) correspondant à la deuxième position et qui est reliée à la masse de référence, et une borne commune aux deux positions, reliée à l'entrée du circuit, la première position correspondant à l'application sur l'entrée (2) du circuit d'un signal de test présentant l'état logique 1 et la deuxième position correspondant à l'application d'un signal de test présentant l'état logique 0, et une autre résistance ($R_1$) connectée en série entre l'entrée du circuit logique et la sortie (6) du moyen de commande (5).

7. Dispositif selon la revendication 6, caractérisé en ce qu'il comporte en outre une diode ($D_1$) connectée en série avec l'autre résistance ($R_1$), la cathode de cette diode étant reliée à l'entrée du circuit logique.

8. Dispositif selon l'une au moins des revendications 6 et 7, caractérisé en ce que la résistance ($R'_2$), l'interrupteur ($I'_T$) et la source (E) sont amovibles, la diode ($D_1$) et l'autre résistance étant reliées à demeure à l'entrée du circuit logique.

9. Dispositif selon l'une quelconque des revendications 1 à 8, caractérisé en ce que le moyen de commande est un capteur dont la sortie fournit des signaux de type «tout ou rien» (états logiques 1 ou 0).

10. Application du dispositif conforme à l'une quelconque des revendications 1 à 9 aux tests automatiques d'une pluralité de circuits logiques par des signaux de test à deux états logiques appliqués aux entrées de ces circuits.

## Patentansprüche

1. Einrichtung zum Anlegen logischer Testsignale zweier Zustände (0 oder 1) an einen Eingang (2) eines logischen Schaltkreises (3), der an einem Ausgang (4) Signale abgibt, die zwei logische Zustände aufweisen, die entsprechend von den zwei logischen Zuständen (0 oder 1) der ihrem Eingang (2) von einem Ausgang (6) einer Steuereinrichtung (5) zugeführten Steuersignale abhängen, dadurch gekennzeichnet, dass sie von einer Einrichtung (1) gebildet ist, die jeden logischen Zustand der Testsignale dem Eingang (2) des logischen Schaltkreises ohne Rücksicht auf den logischen Zustand der Steuersignale aufzwingt.

2. Einrichtung nach Anspruch 1, dadurch gekennzeichnet, dass die Einrichtung (1) zum Aufzwingen jedes logischen Zustandes (0 oder 1) der Testsignale dem Eingang (2) des logischen Schaltkreises (3) eine elektrische Spannungsquelle (E) aufweist, die einen positiven und einen negativen Anschluss aufweist, wobei der negative Anschluss mit einer Bezugsmasse (M) verbunden ist und die Potentiale der positiven und negativen Anschlüsse der Quelle die entsprechenden logischen Zustände 1 und 0 darstellen, und Einrichtungen enthält, um den Eingang des logischen Schaltkreises mit dem positiven Anschluss der Quelle immer dann zu verbinden, wenn ein Testsignal, das den logischen Zustand 1 aufweist, diesem Eingang zugeführt werden muss, um den Eingang des logischen Schaltkreises mit der Bezugsmasse zu verbinden und um die Zuführung des Potentials des positiven Anschlusses der Quelle zum Eingang des Schaltkreises immer dann zu unterbinden, wenn ein Testsignal, das den logischen Zustand 0 aufweist, an den Eingang des logischen Schaltkreises angelegt werden muss.

3. Einrichtung nach Anspruch 2, dadurch gekennzeichnet, dass die Einrichtungen zum Verbinden des Einganges des Schaltkreises mit dem positiven Anschluss der Quelle einen Widerstand ($R_2$) enthalten, der zwischen den Eingang des logischen Schaltkreises und den positiven Anschluss der elektrischen Quelle (E) geschaltet ist, dass die Einrichtungen zum Verbinden des Eingangs des Schaltkreises mit der Bezugsmasse und zum Verhindern der Zuführung des Potentials des positiven Anschlusses der Quelle einen Schalter ($I_T$), der zwischen den Eingang des Schaltkreises und die Bezugsmasse geschaltet ist und dessen Öffnungs- oder Schliesszustand den logischen Zuständen 1 bzw. 0 des Testsignals entspricht, und einen weiteren Widerstand ($R_1$) enthalten, der zwischen den Eingang des logischen Schaltkreises und den Ausgang (6) der Steuereinrichtung (5) geschaltet ist.

4. Einrichtung nach Anspruch 3, dadurch gekennzeichnet, dass sie wenigstens eine Diode ($D_1$) ($D_2$) enthält, die in Serie mit einem der Widerstände ($R_1$) ($R_2$) geschaltet ist.

5. Einrichtung nach wenigstens einem der Ansprüche 3 und 4, dadurch gekennzeichnet, dass die gegebenenfalls vorhandenen Dioden ($D_2$, $D_1$) und die Widerstände ($R_2$, $R_1$) ständig mit dem Eingang des logischen Schaltkreises verbunden sind, dass die elektrische Stromquelle (E) und der Schalter ($I_T$) abschaltbar sind und entsprechend mit dem Widerstand ($R_2$) und dem Eingang des Schaltkreises nur im Augenblick eines Tests verbunden sind.

6. Einrichtung nach Anspruch 2, dadurch gekennzeichnet, dass die Einrichtungen zum Verbinden des Eingangs (2) des Schaltkreises (3) mit dem positiven Anschluss der Quelle (E) und zum Verbinden dieses Einganges mit der Bezugsmasse und zum Verhindern der Zuführung des Potentials des positiven Anschlusses der Quelle einen Widerstand ($R'_2$) enthalten, der mit dem positiven Anschluss der Quelle (E) und mit einem ersten Anschluss eines Schalters ($I'_T$) mit zwei Schaltstellungen verbunden ist, wobei dieser erste Anschluss (13) der ersten Schaltstellung entspricht und dieser Schalter einen zweiten Anschluss (14) aufweist, der der zweiten Schaltstellung entspricht und der mit der Bezugsmasse verbunden ist, und einen beiden Schaltstellungen gemeinsamen Anschluss aufweist, der mit dem Eingang des Schaltkreises verbunden ist, wobei die erste Schaltstellung der Zuführung eines Testsignals des logischen Zustandes 1 zum Eingang (2) des Schaltkreises und die zweite Schaltstellung der Zuführung eines Testsignals des logischen Zustandes 0 entspricht, und einen weiteren Widerstand ($R_1$) enthalten, der in Serie zwischen den Eingang des logischen Schaltkreises und den Ausgang (6) der Steuereinrichtung (5) geschaltet ist.

7. Einrichtung nach Anspruch 6, dadurch gekennzeichnet, dass sie weiterhin eine Diode ($D_1$) enthält, die in Serie mit dem weiteren Widerstand ($R_1$) geschaltet ist, wobei die Kathode dieser Diode mit dem Eingang des logischen Schaltkreises verbunden ist.

8. Einrichtung nach einem wenigstens der Ansprüche 6 und 7, dadurch gekennzeichnet, dass der Widerstand ($R'_2$), der Schalter ($I'_T$) und die Quelle (E) abschaltbar sind, wobei die Diode ($D_1$) und der andere Widerstand ständig mit dem Eingang des logischen Schaltkreises verbunden sind.

9. Einrichtung nach einem der Ansprüche 1 bis 8, dadurch gekennzeichnet, dass die Steuereinrichtung ein Messfühler ist, dessen Ausgang Signale vom Typ «Alles oder Nichts» (logische Zustände 1 oder 0) liefert.

10. Anwendung der Einrichtung nach einem der Ansprüche 1 bis 9 zur automatischen Untersuchung einer Vielzahl logischer Schaltkreise mittels Testsignalen zweier logischer Zustände, die an die Eingänge dieser Schaltkreise gelegt werden.

## Claims

1. Device for applying two-state (0 or 1) logic test signals to an input (2) of a logic circuit (3), said logic circuit providing at an output (4) signals indicating two logic states depending respectively on the two logic states (0 or 1) of command signals supplied to its input (2) by an output (6) of a command means (5), characterized in that it comprises means (1) for applying each logic state of the test signals to the input (2) of the logic circuit, whatever the logic state of the command signals.

2. Device according to Claim 1, characterized in that the means (1) for applying each logic state (0 or 1) of the test signals to the input (2) of the logic circuit (3) comprise an electric potential source (E) having a positive terminal and a negative terminal, the negative terminal being connected to a reference earth (M), the potentials of the positive and negative terminals of the source respectively representing the logic states 1 and 0, and means for connecting the input of the logic circuit to the positive terminal of the source, each time a test signal exhibiting logic state 1 is applied to said input, to connect the input of the logic circuit to the reference earth and to forbid application of potential from the positive terminal of the source to the input of the circuit, each time a test signal exhibiting logic state 0 is applied to the input of the logic circuit.

3. Device according to Claim 2, characterized in that said means for connecting the input of the circuit to the positive terminal of the source comprises a resistance ($R_2$) connected between the input of the logic circuit and the positive terminal of the electric source (E), the means for connecting the input of the circuit to the reference earth and for preventing application of the potential from the positive terminal of the source comprises a switch ($I_T$) connected between the input of the circuit and the reference earth, opening or closing of said switch ($I_T$) corresponding respectively to logic states 1 or 0 of the test signals, and another resistance ($R_1$) connected between the input of the logic circuit and the output (6) of the command means (5).

4. Device according to Claim 3, characterized in that it comprises at least one diode ($D_1$) ($D_2$) connected in series with one of the resistances ($R_1$) ($R_2$).

5. Device according to at least one of Claims 3 and 4, characterized in that the diodes if present ($D_2$, $D_1$) and the resistances ($R_2$, $R_1$) are permanently connected to the input of the logic circuit, the electric current source (E) as well as the switch ($I_T$) being disconnectable and being respectively connected with the resistance ($R_2$) and the input of the circuit only during a test.

6. Device according to Claim 2, characterized in that the means for connecting the input (2) of the circuit (3) with the positive terminal of the source (E) and for connecting said input to the reference earth and preventing application of the potential from the positive terminal of the source comprise a resistance ($R'_2$) connected to the positive terminal of the source (E) and a first terminal of a two-position switch ($I'_T$), said first terminal (13) corresponding to the first position, said switch having a second terminal (14) corresponding to the second position and which is connected to the reference earth, and a terminal common to the two positions connected to the input of the circuit, the first position corresponding to application at an input (2) of the circuit of a test signal exhibiting logic state 1, and the second position corresponding to the application of a test signal exhibiting logic state 0, and another resistance ($R_1$) connected in series

between the input of the logic circuit and the output (6) of the command means (5).

7. Device according to Claim 6, characterized in that it additionally comprises a diode (D₁) connected in series with the other resistance (R₁), the cathode of said diode being connected to the input of the logic circuit.

8. Device according to at least one of Claims 6 and 7, characterized in that the resistance (R'₂), the switch (I'ᴛ) and the source (E) are detachable, the diode (D₁) and the other resistance being permanently connected to the input of the logic circuit.

9. Device according to any one of Claims 1 to 8, characterized in that the command means is a pick-up whose output provides "all or nothing" signals (logic states 1 or 0).

10. Application of the device according to any one of Claims 1 to 9 for automatic tests of a plurality of logic circuits by application of test signals of two logic states to the inputs of said circuits.

FIG.1

FIG.2

0 088 684

# FIG.3

15

FIG.4